(19) **Europäisches Patentamt / European Patent Office / Office européen des brevets**

(11) **EP 1 755 225 A2**

(12) # EUROPÄISCHE PATENTANMELDUNG

(43) Veröffentlichungstag:
   **21.02.2007 Patentblatt 2007/08**

(51) Int Cl.:
   *H03M 1/12* *(2006.01)*    *H03M 1/16* *(2006.01)*
   *H03M 1/10* *(2006.01)*

(21) Anmeldenummer: **06017230.1**

(22) Anmeldetag: **18.08.2006**

(84) Benannte Vertragsstaaten:
   **AT BE BG CH CY CZ DE DK EE ES FI FR GB GR HU IE IS IT LI LT LU LV MC NL PL PT RO SE SI SK TR**
   Benannte Erstreckungsstaaten:
   **AL BA HR MK YU**

(30) Priorität: **19.08.2005 DE 102005039622**

(71) Anmelder: **Micronas GmbH**
   **79108 Freiburg i. Br. (DE)**

(72) Erfinder: **Bauer, Achim**
   **9500 Villach (AT)**

(74) Vertreter: **Göhring, Robert**
   **Patentanwälte**
   **Westphal, Mussgnug**
   **Am Riettor 5**
   **78048 Villingen-Schwenningen (DE)**

(54) **Schaltung zum Durchführen einer Analog-Digital-Konvertierung und Analog-Digital-Konvertierungsverfahren**

(57)    Die Erfindung bezieht sich auf ein Analog-Digital-Konvertierungsverfahren, bei dem ein analoges Signal (inp, inn) in digitale Daten umgesetzt wird, wobei das analoge Signal einer Grob-Analog-Digital-Konvertierung in einem ersten Analog-Digital-Wandler (13) einer ersten Stufe (13 - 15) angelegt wird, das analoge Signal zusätzlich einer Zwischenverstärkung in zumindest einem Zwischenverstärker (16, ZV1 - ZV4) aus zumindest zwei Verstärkerstufen (A1, A2) angelegt wird, der Zwischenverstärkung zusätzlich ein in der ersten Stufe erzeugtes Referenzsignal (refh, refl, refhh, refll) angelegt wird und ein durch die Zwischenverstärkung unter Einsatz des Referenzsignals und des analogen Signals erzeugtes Ausgangssignal einer Fein-Analog-Digital-Konvertierung einer dritten Stufe (17 - 19) mit einem zweiten Analog-Digital-Wandler (19) zum Bereitstellen der digitalen Daten angelegt wird. Die Erfindung bezieht sich außerdem auf eine Analog-Digital-Konvertierungs-Schaltung zum Durchführen einer Analog-Digital-Konvertierung mit einem Analog-Digital- Wandler (15) zum Umsetzen eines analogen Signals in digitale Daten und zumindest einem Zwischenverstärker (16, ZV1 - ZV4) aus zumindest zwei unausgesteuerten Verstärkerstufen (A1, A2), wobei der Zwischenverstärker (16) dem Digital-Analog-Wandler (19) vorgeschaltet ist und einem weiteren Digital-Analog-Wandler (13) nachgeschaltet ist.

**EP 1 755 225 A2**

## Beschreibung

Die Erfindung bezieht sich auf eine Schaltung zum Durchführen einer Analog-Digital-Konvertierung mit den oberbegrifflichen Merkmalen des Patentanspruchs 1 und ein Analog-Digital-Konvertierungsverfahren mit den oberbegrifflichen Merkmalen des Patentanspruchs 15.

Als Hochgeschwindigkeitswandler sind verschiedene Schaltungen zum Durchführen einer Analog-Digital-Konvertierung bekannt. Dies sind ein konventioneller Flash-ADC (ADC: Analog Digital Converter / Analog-Digital-Wandler), ein Pipeline-ADC sowie ein folding (faltender) ADC.

Ein konventioneller Flash-ADC, der Daten in zwei Schritten (two step) umsetzt, ist bekannt aus IEEE JOURNAL OF SOLID-STATE CIRCUITS, Vol. 34, Nr. 5, Mai 1999. Nachteilhaft sind dabei ein größerer Flächenbedarf bei mehrfacher Ausführung von erforderlichen Feinstufen und, falls nicht interpoliert wird, eine große kapazitive Belastung eines Signaleinganges. Nachteilhaft ist außerdem ein erhöhter Leistungsverbrauch in den Feinstufen, um dort kleine Spannungsdifferenzen ausreichend schnell zu verstärken. Feinkomparatoren limitieren maßgeblich die maximale Samplefrequenz (Abtastfrequenz).

Ein Pipeline-ADC ist bekannt aus ISSCC 2005, Digest of Technical Papers, S. 276-285 Pipelined ADCs. Nachteilhaft ist ein hoher Leistungsverbrauch durch erforderliche Verstärker insbesondere bei sehr hohen Konvertierungsraten, um die Verzögerung entlang einer Schleife eines Sample & Hold-ADC-DAC-Residueamplifier (Abtastender und haltender Analog-Digital-Wandler-Digital-Analog-Wandler-Residuenverstärker) klein zu halten.

Ein folding (faltender) ADC, der auch eine Interpolierung vornimmt, ist bekannt aus Allen Holberg, CMOS Analog Circuit Design, wobei in diesem Buch auch ein Überblick über verschiedene andere Wandlerarchitekturen gegeben wird. Nachteilhafterweise wird beim folding (faltender) ADC bei mehr als acht Bit Auflösung und hohen Samplefrequenzen die kapazitive Belastung durch die Folding-Schaltungen kritisch. Außerdem wird eine Sample & Hold-Stufe benötigt. Die Architektur ist schwierig umzusetzen und wird selten verwendet.

Die Aufgabe der Erfindung besteht darin, ein leistungssparendes AD-Konvertierungsverfahren und eine leistungssparende AD-Konvertierungsschaltung für Hochgeschwindigkeitsanwendungen bereitzustellen.

Diese Aufgabe wird durch eine Schaltung zum Durchführen einer Analog-Digital-Konvertierung mit den Merkmalen des Patentanspruchs 1 bzw. durch ein Analog-Digital-Konvertierungsverfahren mit den Merkmalen des Patentanspruchs 15 gelöst.

Vorteilhafte Ausgestaltungen sind Gegenstand von abhängigen Ansprüchen.

Bevorzugt wird demgemäss eine Analog-Digital-Konvertierungs-Schaltung zum Durchführen einer Analog-Digital-Konvertierung mit einem Analog-Digital-Wandler zum Umsetzen eines analogen Signals in digitale Daten und mit zumindest einem Zwischenverstärker aus zumindest zwei Verstärkerstufen, wobei der Zwischenverstärker dem Analog-Digital-Wandler vorgeschaltet ist.

Bevorzugt wird insbesondere eine Schaltung, bei der/die Verstärkerstufen jeweils als eine unausgesteuerte Verstärkerstufe ausgebildet sind und eine Ausgangsspannung besitzen, die in guter Näherung ihrer Eingangsspannung proportional ist.

Bevorzugt wird insbesondere eine Schaltung, bei der die Ausgangsspannungen zweier solcher Verstärkerstufen als Zwischenverstärker abwechselnd jeweils mit unterschiedlichen, insbesondere differentiellen Referenzspannungspaaren, aber mit derselben differentiellen Signalspannung beschaltet werden. Bevorzugt wird insbesondere eine Schaltung, bei der die Referenzspannungspaare differentielle Referenzspannungspaare sind.

Bevorzugt wird insbesondere eine Schaltung, bei welcher der oder die Zwischenverstärker verschaltet ist/sind, um mittels des nachfolgenden Analog-Digital-Wandlers die Ermittlung der Lage von Signalspannungen relativ zu Referenzspannungen durchzuführen.

Bevorzugt wird insbesondere eine Schaltung, bei welcher der oder die Zwischenverstärker verschaltet ist/sind als eine Mittelstufe zwischen einem Grob-Analog-Digital-Wandler als vorhergehende Stufe und einem Fein-Analog-Digital-Wandler als nachfolgende Stufe. Bevorzugt wird insbesondere eine Schaltung, bei welcher der Grob-Analog-Digital-Wandler und/oder der Fein-Analog-Digital-Wandler jeweils mit averaging und interpolation Techniken implementiert sind. Bevorzugt wird insbesondere eine Schaltung, bei welcher der Fein-Analog-Digital-Wandler in seiner ersten Stufe mit resistivem Averaging umgesetzt ist.

Bevorzugt wird insbesondere eine Schaltung, bei welcher der/die Zwischenverstärker mit einem Referenzspannungsausschnitt beschaltet werden, der aus einem Resultat der vorhergehenden Stufe generiert wird.

Bevorzugt wird insbesondere eine Schaltung, bei welcher der/die Zwischenverstärker als Mittelstufe aus mehreren nebenläufig arbeitenden Zwischenverstärkern zusammen geschaltet sind. Bevorzugt wird insbesondere eine Schaltung, bei welcher den Zwischenverstärkern eine Arbitrierungsschaltung vorgeschaltet und ein Multiplexer nachgeschaltet ist. Bevorzugt wird insbesondere eine Schaltung mit einer an den Grob-Analog-Digital-Wandler und/oder den Fein-Analog-Digital-Wandler geschalteten Kalibrierungsschaltung zum Anlegen und Auswerten einer insbesondere flachen Spannungsrampe an die Arbitrierungsschaltung und den Eingang des Grob-Analog-Digital-Wandlers.

Bevorzugt wird insbesondere eine Schaltung, bei welcher die Zwischenverstärker jeweils ausgebildet sind durch einen kapazitiven Ring, der zwischen Ausgänge zweier Verstärker mit Ausgangssignalen geschaltet ist und der mittels Flash-Schaltern ausgelegt ist, in einer Flash-Phase zusätzlich zu den Zwischenverstärkern eine Analog-Digital-Wandler-Endstufe zu treiben. Bevorzugt wird insbesondere eine Schaltung, bei welcher die Zwischenverstärker geschaltet sind, eine Differenz zu anliegenden Referenzsignalen zu verstärken.

Bevorzugt wird verfahrensgemäß ein Analog-Digital-Konvertierungsverfahren, bei dem ein analoges Signal in digitale Daten umgesetzt wird, wobei das analoge Signal einer Grob-Analog-Digital-Konvertierung in einem ersten Analog-Digital-Wandler einer ersten Stufe angelegt wird, das analoge Signal zusätzlich einer Zwischenverstärkung in zumindest einem Zwischenverstärker aus zumindest zwei Verstärkerstufen angelegt wird, der Zwischenverstärkung zusätzlich ein in der ersten Stufe erzeugtes Referenzsignal angelegt wird und ein durch die Zwischenverstärkung unter Einsatz des Referenzsignals und des analogen Signals erzeugtes Ausgangssignal einer Fein-Analog-Digital-Konvertierung einer dritten Stufe mit einem zweiten Analog-Digital-Wandler zum Bereitstellen der digitalen Daten angelegt wird.

Bevorzugt wird insbesondere ein Verfahren, bei dem mittels zweier unausgesteuerter Verstärkerstufen mit einer Ausgangsspannung, die in insbesondere guter Näherung ihrer Eingangsspannung proportional ist, jeweils ein solcher Zwischenverstärker ausgebildet wird, wobei die Verstärkerstufen abwechselnd jeweils mit den unterschiedlichen, insbesondere differentiellen Referenzspannungspaaren, aber mit der selben differentiellen Signalspannung beschaltet werden.

Bevorzugt wird insbesondere ein Verfahren, bei dem mittels der Zwischenverstärker und dem zweiten Analog-Digital-Wandler eine Ermittlung einer Lage der Signalspannungen relativ zu den Referenzspannungen durchgeführt wird.

Bevorzugt wird insbesondere ein Verfahren, bei dem die Zwischenverstärker mit einem Referenzspannungsausschnitt beschaltet werden, der aus dem Resultat der ersten Stufe generiert wird.

Bevorzugt wird insbesondere ein Verfahren, bei dem ein Kalibrationsvorgang einmalig oder wiederholt durch ein Anlegen und eine Auswertung einer flachen Spannungsrampe durchgeführt wird, wobei das Anlegen an eine den Zwischenverstärkern vorgeschaltete Arbitrierungsschaltung und an den Eingang des Grob-Analog-Digital-Wandlers durchgeführt wird.

Bereitgestellt wird somit ein leistungssparendes AD-Konvertierungsverfahren für Hochgeschwindigkeitsanwendungen mittels Verwendung einer mehrstufigen Topologie und einer Kalibrationsschaltung.

Ermöglicht wird im Vergleich zum konventionellen Flash-ADC ein moderater Flächenverbrauch, da die Schaltung gegenüber einem two-step flash keine Mehrfachausführung der Feinstufe benötigt und die einzelnen ADC-Blöcke interpoliert ausgeführt werden können. Vorteilhaft ist außerdem ein geringerer Leistungsverbrauch.

Ermöglicht wird im Vergleich zum Pipeline-ADC ein sehr geringer Leistungsverbrauch, da die Feinstufe nur einfach ausgeführt ist und die differentielle Feinwandlung nicht zwei Phasen, sampling (abtasten) und amplification (verstärken) benötigt, sondern nur ein einzelner, differentieller Flashvorgang erforderlich ist, der auf einem vorverstärkten Signalpegel basiert. Die Komparatorstruktur kann daher auf einen niedrigen Stromverbrauch hin ausgelegt werden.

Ermöglicht wird im Vergleich zum folding ADC eine moderate Belastung der Signal- und Referenzeingänge, da nur der insbesondere interpolierte Grobwandler und die jeweils aktiven Zwischenstufen zu treiben sind.

Mögliche Anwendungen sind insbesondere AD-Wandler in Applikationen mit sehr hohen Sampleraten und Auflösungen von 8 - 12 Bit bei gleichzeitig sehr geringem Leistungsverbrauch. Ein Einsatz als gemultiplexter ADC für mehrere Videokanäle ist ebenfalls möglich, dies vorzugsweise mit vier Zwischenverstärkern. Da die Schaltung einen moderaten Flächenbedarf aufweist und sehr wenig Leistung verbraucht, ist sie generell für Applikationen geeignet, bei denen hohe Signalfrequenzen gewandelt werden müssen, wie z.B. im Fall mobiler Applikationen.

Ein Ausführungsbeispiel wird nachfolgend anhand der Zeichnung näher erläutert. Es zeigen:

Fig. 1      ein Gesamtschaltbild des AD-Wandlers mit vier Mittelstufen,

Fig. 2      einen Überkreuz-Vergleich von Zwischenverstärkerausgängen eines solchen AD-Wandlers,

Fig. 3      eine Referenzbeschaltung des Zwischenverstärkers,

Fig. 4      ein Prinzip-Schaltbild des Zwischenverstärkers,

Fig. 5      eine Ansteuerung der Endstufe eines solchen AD-Wandlers,

Fig. 6      Steuersignale einzelner ADC-Module,

Fig. 7      Fehlerbilder aufgrund a) einer Verstärkungs-Fehlanpassung (gain mismatch), b) eines Offsets und c) einer Verstärkungs-Saturation (Sättigung),

Fig. 8      eine Abweichung einer Zwischenverstärker-Charakteristik von einer Ideallinie,

Fig. 9    ein Kalibrationssignal,

Fig. 10    eine Kalibrationsquelle und

Fig. 11    einen beispielhaften Algorithmus für vier Zwischenverstärker zur Detektion und Verarbeitung von Soll-Istwert-Abweichungen.

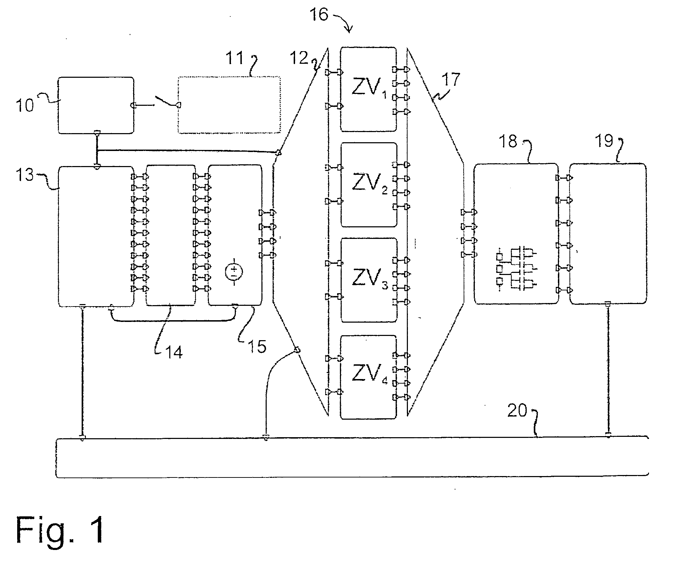

Ein erster Aspekt des Konzeptes ist eine AD-WandlerArchitektur. Wie aus Fig. 1 ersichtlich, besteht eine beispielhafte Schaltung aus einer Vielzahl miteinander verschalteter Komponenten. Ein Signalpfad 10 ist an eine Kalibrationsquelle 11 schaltbar. Der Signalpfad 10 ist an eine Arbitrierungsschaltung 12 angeschlossen. Außerdem ist der Signalpfad 10 an (einen interpolierenden und mittelnden) ADC (Analog-Digital-Wandler) 13 angeschlossen. Der ADC 13 ist über eine Vielzahl paralleler Verbindungen mit einem Decoder 14 verbunden. Der Decoder 14 ist über eine Vielzahl paralleler Verbindungen mit einem Referenzgenerator 15 verbunden. Der Referenzgenerator 15 ist über eine Vielzahl paralleler Verbindungen mit der Arbitrierungsschaltung 12 verbunden, wobei die Anzahl der Verbindungen vorzugsweise einer Anzahl von Zwischenverstärkern 16 entspricht.

Die Zwischenverstärker 16 sind zwischen die Arbitrierungsschaltung 12 und einen Multiplexer 17 geschaltet. Bei der dargestellten Ausführungsform sind vier Zwischenverstärker 16, ZV1 - ZV4 mit zwei Verbindungen an die Arbitrierungsschaltung 12 und mit vier Verbindungen an den Multiplexer 17 geschaltet.

Der Multiplexer 17 ist über vier Verbindungen an ein resistives, kapazitives Teilernetz 18 angeschlossen. Das Teilernetz 18 ist über parallele Verbindungen an einen weiteren interpolierenden und mittelnden ADC 19 angeschlossen. Die Arbitrierungsschaltung 12, der ADC 13 und der weitere ADC 19 sind an eine digitale Schaltung zur Evaluation und Kalibration 20 angeschlossen.

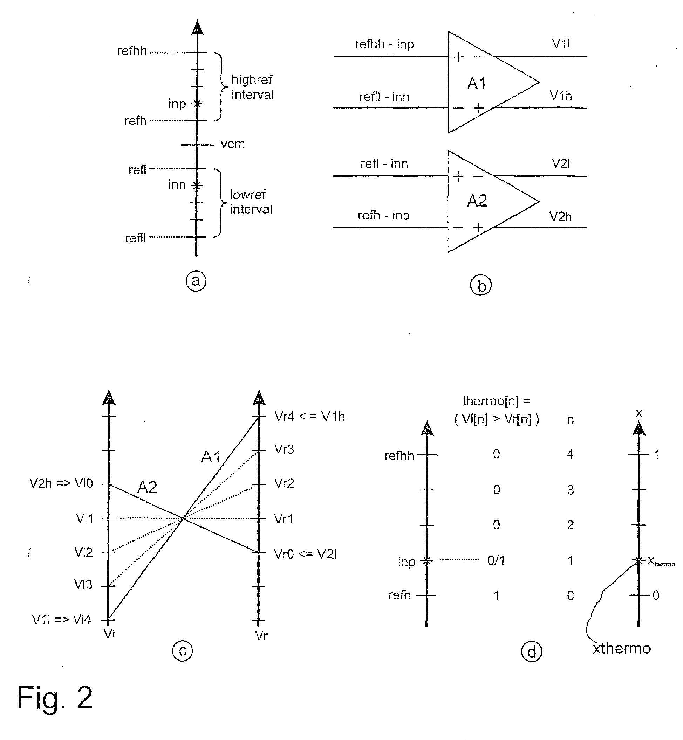

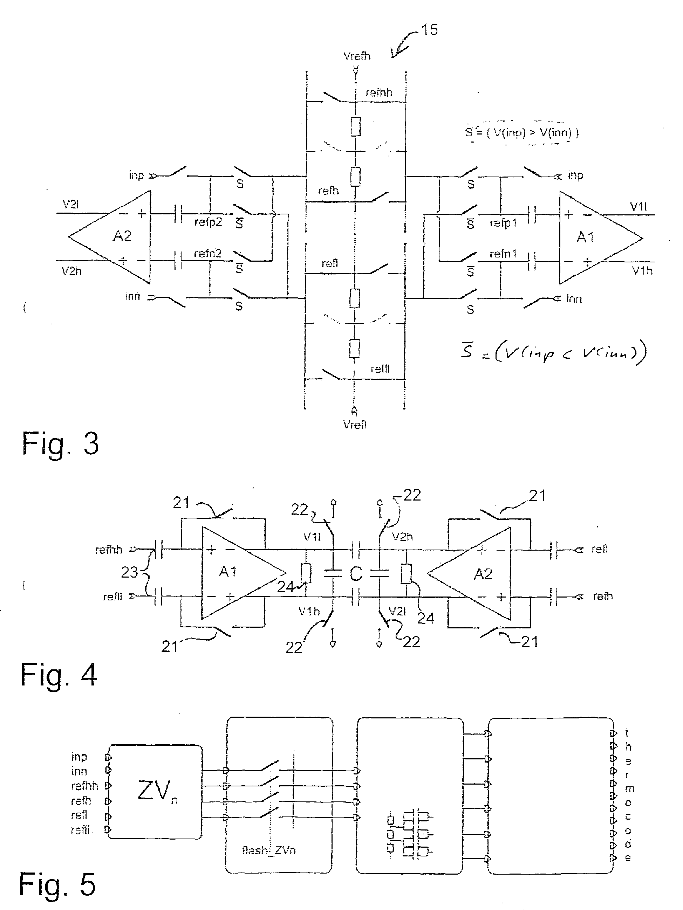

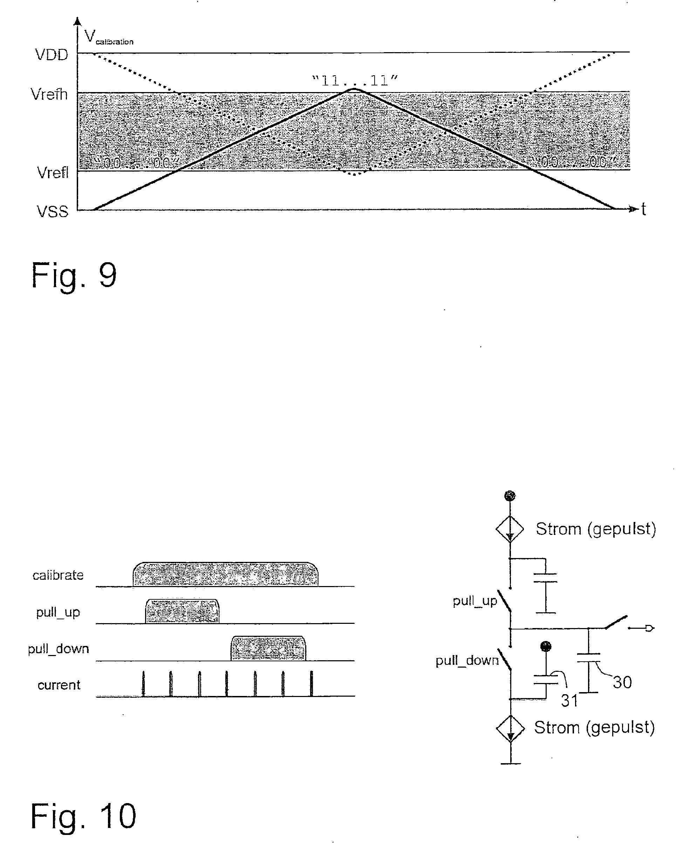

Ein Kerngedanke besteht darin, dass eine unausgesteuerte Verstärkerstufe eine Ausgangsspannung besitzt, die in guter Näherung ihrer Eingangsspannung proportional ist. Die Ausgangsspannungen zweier solcher Verstärkerstufen, die im folgenden als Zwischenverstärker 16 bezeichnet werden und die abwechselnd jeweils mit unterschiedlichen, insbesondere differentiellen Referenzspannungspaaren, aber mit derselben differentiellen Signalspannung beschaltet werden (Fig. 2), ermöglichen mittels einer geeigneten Verschaltung (Fig. 4) und des nachfolgenden AD-Wandlers 19 (Fig. 5) die Ermittlung der Lage der Signalspannungen relativ zu den Referenzspannungen. Die Zwischenverstärker 16 bilden vorzugsweise die zweite bzw. Mittelstufe des gesamten ADCs. Die Zwischenverstärker 16 werden in diesem Fall mit einem Referenzspannungsausschnitt beschaltet, der aus dem Resultat der vorhergehenden Stufe generiert wird (Fig. 3). Die Mittelstufe setzt sich vorzugsweise aus mehreren nebenläufig arbeitenden Zwischenverstärkern 16, ZV1 - ZV4 zusammen (Fig. 1), um durch Parallelisierung die Konvertierungsrate zu erhöhen. Je nach Auslegung bzw. Dimensionierung der Schaltung kann ein Kalibrationsvorgang zum Eichen einer digitalen Korrekturlogik erforderlich sein. Dieser Korrekturvorgang kann einmalig oder wiederholt durch das Anlegen und die Auswertung einer flachen Spannungsrampe erfolgen (Fig. 9).

Ein wesentliches Element der Schaltungsanordnung sind die Zwischenverstärker 16.

Die Ausgangsspannung einer idealen Verstärkerstufe ist proportional zu ihrer Eingangsspannung. Zwei solche Verstärkerstufen A1 und A2 werden vorzugsweise differentiell angesteuert. Dabei wird beispielsweise zuerst ein differentielles Signalspannungspaar inp und inn eingesampelt und danach werden die beiden differentiellen Referenzpaare refhh und refll sowie refh und refl an die Zwischenverstärker 16 geschaltet (Fig. 2a und 2b). Die ausgesteuerten Knoten der beiden idealen Verstärker werden anschließend kapazitiv oder resistiv geteilt, gemäß Fig. 1c exemplarisch mit 2-Bit-Teilung, und einer ADC-Feinstufe zugeführt. Dabei ergibt sich ein n-tes Bit der Feinstufe jeweils aus dem Vergleich einer ersten und einer zweiten Verstärker-Ausgangsspannung Vl[n] > Vr[n]. Ein "1/0"-Umbruch im vom weiteren ADC 19 angelegten Thermometercode x, normiert auf 1, entspricht gemäß Formel 1 bei gleicher Verstärkung A1 = A2 der relativen Lage xthermo des differentiellen Signalpegels innerhalb zweier Referenzintervalle highref und lowref (Fig. 2d). Die normierte Lage des Thermometer-Umbruchs folgt in Abhängigkeit von den Eingangssignalen bzw. Signalspannungen inp, inn und den Referenzenspannungen refhh, refll, refh, refl gemäß

$$x_{thermo} = \frac{1}{1 + \dfrac{A1}{A2} \cdot \dfrac{1-x}{x}} \qquad \text{mit} \qquad x = \frac{(inp - inn) - (refh - refl)}{(refhh - refll) - (refh - refl)} \qquad (1)$$

falls refh < inp < refhh und refll < inn < refl .

Der aus dem Vergleich resultierende Umbruch des Thermometercodes der Endstufe 19 gibt die Lage der differentiellen Signalspannung innerhalb der jeweiligen Referenzintervalle abgesehen vom Diskretisierungsfehler maßstabsgetreu gemaess Fig. 1c wieder.

Die optimale Verstärkung für die Zwischenstufen ergibt sich aus der geforderten Auflösung der Grobstufe bzw. aus dem inversen Verhältnis von Referenzintervall zu dem näherungsweise linearen Aussteuerbereich der Zwischenverstärker 16. Für eine 10-Bit-Architektur setzen sich die Zwischenverstärker 16 typischerweise aus jeweils einer Stufe hoher Verstärkung, z.B. 12, oder aus jeweils zwei aufeinanderfolgenden Stufen mit moderatem Gain (Verstärkung), z.B. 3 * 4, zusammen.

Fig. 4 zeigt das Schaltungsprinzip der Mittelstufe mit den Zwischenverstärkern 16 anhand zweier beispielhafter Verstärker A1 und A2. Die Verstärker A1 und A2 können vorzugsweise mit kapazitiv gekoppelten Differentialstufen realisiert werden. Beispielsweise sind während der Abtast-Phase Abtast-Schalter 21 geschlossen und das differentielle Signal V1l, V1h wird in Eingangskapazitäten 23 gespeichert. Dadurch wird auch eine Offsetkompensation ermöglicht. In einer anschließenden Verstärkungsphase wird die Differenz zu anliegenden Referenzsignalen refhh, refll verstärkt und das Ergebnis in einem kapazitiven Ring C gespeichert, der zwischen die Ausgänge der Verstärker A1, A2 mit den Ausgangssignalen V1h, V1l bzw. V2h, V2l geschaltet ist. Diesen kapazitiven Ring C treibt in einer Flash-Phase zusätzlich zu den Zwischenverstärkerstufen die ADC-Endstufe. Flash-Schalter 22 des kapazitiven Rings C werden vorzugsweise als gate-boosted switches (Gate-verstärkte Schalter) ausgelegt.

Widerstände 24 können beidseits des kapazitiven Rings C zwischen die Ausgänge der Verstärker A1, A2 geschaltet dazu dienen, die Verstärkung der Stufen anzupassen. Parallel zu den Ringkapazitäten koennen Schalter eingebaut werden, welche die Ringkapazitäten zu Beginn der Abtast-Phase entladen.

Zur Ansteuerung der Zwischenverstärker 16 bilden die Zwischenverstärker 16 vorzugsweise die Mittelstufe des gesamten ADCs.

In diesem Fall werden sie jeweils mit einem Referenzspannungspaar refhh/refll (=Vrefh) bzw. refh/refl (=Vrefl) beschaltet, der aus dem Resultat der vorhergehenden Stufe, vorzugsweise eines Flash ADCs, generiert wird. Fig. 3 stellt das Schaltungsprinzip einer möglichen Implementierung dar. Die Schalter werden so angesteuert, dass abwechselnd die differentielle Signalspannung in der Abtast- bzw. Sampling-Phase und die differentiellen Referenzpaare in der Verstärkungs-Phase an die Zwischenverstärker A1, A2 angelegt werden. Durch einen beidseitigen Überhang wird bei den Referenzintervallen sichergestellt, dass die differentiellen Signalspannungen trotz Nichtidealitäten innerhalb der jeweiligen vom Grobwandler ermittelten Intervalle liegen. Vorzugsweise wird in einer Flash-Architektur ein beidseitiger Überhang implementiert, der in Summe dem Intervall entspricht, in dem die Signalspannung idealerweise liegen sollte. Besitzt der Grobwandler, der mit M Bit vor der Mittelstufe angeordnet ist, eine Auflösung $Vpp/2^M$, so beträgt der Überhang nach oben und unten jeweils $Vpp/2^{M+1}$. Insgesamt wird also ein LSB (niederwertigstes Bit) des Grobwandlers als beidseitiger Überhang vorgesehen. Der Referenzteiler 15, der vorzugsweise aus einer Kette parallelgeschalteter Widerstände und Kapazitäten besteht, ist so dimensioniert, dass entlang zweier RC-Elemente (RC: Widerstand-Kapazität) die Spannung $Vpp/2^{M-1}$ abfällt. Der Referenzteiler bzw. Referenzgenerator 15 besitzt typischerweise $2^M$ Glieder. Der Abgriff für die Zwischenverstärker A1, A2 erfolgt also jeweils über zwei Glieder, so dass ein beidseitiger Überhang von jeweils einem halben Grob-Bit bereitgestellt wird. Jedes RC-Glied kann jeweils gemäß Fig. 3, in der beispielhaft ein rein resistiver Teiler dargestellt ist, über zwei Schalter mit den Netzen refp1 und refn1 bzw. refp2 und refn2 verbunden werden.

Dies geschieht beispielhaft in einer Weise, so dass jeweils die Polaritaet von refp1 nach refn1 bzw. von refp2 nach refn2 mit der von inp nach inn uebereinstimmt: gemaess Fig. 3 sind hierfuer die Schalter S leitend wenn V(inp) > V(inn) und anderenfalls die Schalter S̄.

Dabei ist refp1, refp2 ein an den positiven Eingang des ersten bzw. zweiten Verstärkers A1, A2 über einen Kondensator angelegtes Signal, refn1, refn2 ein an den negativen Eingang des ersten bzw. zweiten Verstärkers A1, A2 über einen Kondensator angelegtes Signal und inp, inn ist das differentielle Eingangssignal.

Um die Belastung des Signalpfades zu verringern und die AD-Konvertierungsrate zu maximieren werden gate-boosted switches insbesondere als Signal- und Referenzschalter für den Grob-ADC 13 - 14 und bei den Signal- bzw. Sample-Schaltern der Zwischenverstärker 16, A1, A2, sowie für reset-Schalter bevorzugt eingesetzt. Vorzugsweise sollten sie auch beim Flashen der Endstufe im Multiplexer 17 verwendet werden.

Eine Ansteuerung der Endstufe erfolgt über die Zwischenverstärker 16. Die Zwischenverstärker 16, ZV1 - ZV4 steuern den Fein-ADC 17 - 19 im Multiplexverfahren an. Jeweils einer der Zwischenverstärker ZV1 - ZV4 wird dabei zum Flashen der Endstufe durchgeschaltet, während sich die anderen noch in der Verstärkungsphase befinden und ein anderer der Zwischenverstärker 16, ZV1 - ZV4 gerade das anliegende Signal inp, inn sampelt. Typischerweise treibt der Zwischenverstärker 16 während dem Flash den aus Widerständen und/oder Kapazitäten aufgebauten Eingangsteiler 18 des Fein-ADCs (Fig. 5). Der Eingangsteiler 18 kann analog zum Referenzteiler bzw. Referenzgenerator 15 für die Zwischenverstärker 16 beispielsweise als Kette paralleler RC-Glieder realisiert werden.

Der Fein-ADC 18 - 19 wird vorzugsweise mit für sich bekannten averaging und interpolation Techniken implementiert, so dass keine eigene Phase zur Kompensation des Offsets nötig ist. Generell ist der Offset der Endstufe aufgrund der vorausgehenden Zwischenverstärkung entsprechend weniger kritisch.

Auch beim Grob-ADC 13 - 14 wirken sich Averaging und Interpolation vorteilhaft aus, indem sie die Eingangslast für die Signaltreiber 10 gering halten und Offset-Effekte vermindern sowie den Leistungsverbrauch minimieren. So kann der Grob-ADC beispielsweise in der ersten Stufe resistives Averaging benutzen, wodurch die Verstärkung der ersten Stufe reduziert wird. Damit wird zwischen erster und zweiter Stufe eine kapazitive Teilung von zwei Bit praktikabel. Durch diese interne Teilung ist die Eingangslast des Grob-ADCs entsprechend geringer.

Nachfolgend wird eine bevorzugte ADC-Topologie beschrieben.

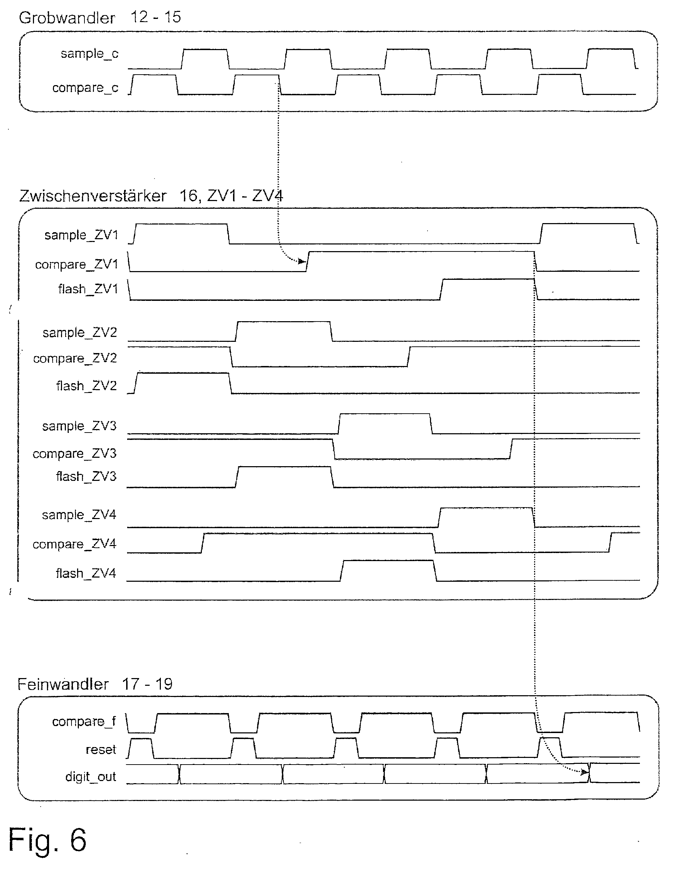

Ein Charakteristikum der beschriebenen ADC-Architektur ist die Rautenform gemäß Fig. 1. An einen Grobwandler mit M Bit sind die Zwischenverstärker 16 angeschlossen, welche zyklisch einen Feinwandler mit N - M + 1 Bit wegen einem Überhang-Bit flashen. Dabei ist N die Auflösung des Wandlers und M die Auflösung des Grobwandlers. In Fig. 1 ist beispielhaft eine Topologie mit den vier Zwischenverstärkern ZV1 - ZV4 dargestellt. Die Ansteuerung der Zwischenverstärker ZV1 - ZV4 erfolgt zyklisch über den Arbiter 12 gemäß Fig. 6. Im Grobwandler wechseln sich typischerweise sampling-Phase mit einem Abtastsignal sample_c = 1 für den Abtastzustand und Referenz- bzw. Komparationsphase mit einem dazu gegenläufig getakteten Komparationssignal compare_c = 1 ab. Mit der fallenden Flanke des Komparationssignals compare_c werden die verstärkten Pegel eingelatcht und nach einer durch einen punktierten Pfeil verbildlichten Verzögerung können die aus dem Groberergebnis derart generierten Referenzintervalle Vrefh, Vrefl über den zyklischen Arbiter 12 an die jeweiligen Zwischenverstärker ZV1 - ZV4 geschaltet werden mittels Zwischenverstärker-Komparationssignalen compare_ZV1 - compare_ZV4. Diese haben vorher während entsprechender Zwischenverstärker-Abtastsignale sample_ZV1 = 1 - sample_ZV4 die differentielle Signalspannung gespeichert. Die Samplephase der Zwischenverstärker ZV1 - ZV4 setzt vorzugsweise etwas früher ein als beim Grobwandler, sie endet allerdings für beide Module synchron. Die Referenz- bzw. Komparationsphase der Mittelstufen kann über zwei volle Taktperioden andauern, so dass genügend Zeit für ein Setzen bzw. Settling der Pegel und ein Treiben der Flashkapazitäten im kapazitiven Ring C (Fig. 4) vorhanden ist. Gegen Ende der Komparationsphase wird die Feinstufe über den Multiplexer 17 geflasht mittels eines entsprechenden Flashsignals flash_ZV1 - flash_ZV4 im gesetzten Zustand (= 1). Zu Beginn der Flashphase kann im Feinwandler noch ein kurzer Pegelreset der Feinstufen stattfinden, indem ein Rücksetzsignal reset gesetzt wird (=1). Mit der fallenden Flanke eines Feinwandler-Vergleichssignals compare_f werden die Pegel im Feinwandler eingelatcht und schließlich mit einer Takt- bzw. clock-Flanke ausgegeben. Die anderen Mittelstufen, welche durch die anderen der Zwischenverstärker ZV2 - ZV4 gebildet werden, werden jeweils zueinander zyklisch versetzt in der gleichen Weise geschaltet wie dieser erste Zwischenverstärker ZV1.

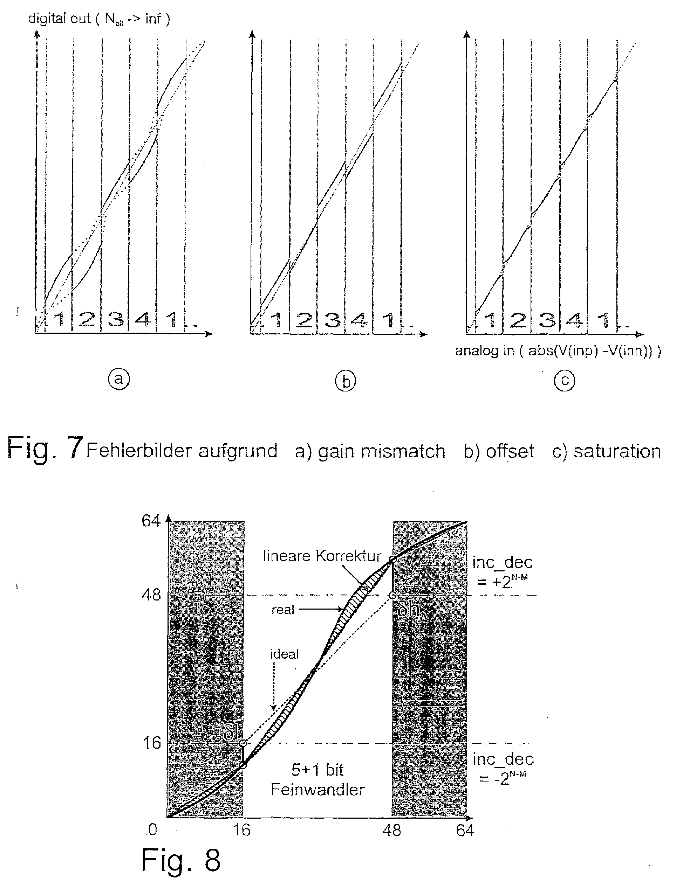

Die Ermittlung des digitalen Ausgangswertes geschieht typischerweise gemäß der nachfolgenden Kalkulation. Ein binäres Gesamtergebnis dig_ges des Wandlers setzt sich dabei aus mehreren Termen zusammen, einem Binärergebnis dig_grob des Grobwandlers bzw. der Eingangsstufe, einem Überlapp-Bit, einem Feinergebnis-Signal inc_dec abhängig vom korrigierten Feinergebnis (Fig. 8), einem Binärergebnis dig_fein des Feinwandlers bzw. der Endstufe und einem Korrekturwert dig_cor abhängig vom Feinergebnis (Fig. 4).

Für einen N-Bit AD-Wandler mit einer M-Bit Grobstufe und einem Bit-Überhang im Referenzintervall ergibt sich zur Evaluierung des Digitalergebnisses

$$[\text{dig\_ges}] = [\text{dig\_grob \& "0...0"}] + ["0...0" \& \text{dig\_fein}] - 2^{N-M-1} + \text{inc\_dec} - \text{dig\_cor} \quad (2)$$

$$\vee \qquad \vee \qquad \vee \qquad \vee \qquad \vee$$

$$\text{N Bit} \quad \text{M Bit} \quad \text{N-M Bit} \quad \text{M-1 Bit} \quad \text{N-M+1 Bit}$$

Das Feinergebnis-Signal und der inc_dec-Wert +/-2^{N-M} werden in der Feinstufe erzeugt, falls das korrigierte Feinergebnis den Sollbereich über/unterschreitet, wie dies aus Fig. 8 ersichtlich ist. Zwischen dem Abschluss der Samplephase des analogen Eingangssignals und der Ausgabe des dazugehörigen Digitalwertes vergeht typischerweise eine Latenzzeit von $N_{ZV}$ + [1..2] Takten mit $N_{ZV}$ als Anzahl der Mittelstufen bzw. Zwischenverstärker 16.

Um beispielsweise eine 10-Bit Topologie auf eine Minimierung des Verbrauchs hin zu optimieren, können sämtliche Verstärker in den Komparatoren und den Mittelstufen jeweils aus zwei aufeinanderfolgenden Differentialstufen aufgebaut werden. Wenn sowohl beim Grob- als auch beim Fein-Wandler für sich bekannte Averaging- und Interpolationsverfahren zum Einsatz kommen, lassen sich beide Wandler 13, 19 zusammen mit lediglich 80 Differentialstufen realisieren. Werden noch einmal 16 Differentialstufen für die Zwischenverstärker 16 und 2 mA Stromfluss im Referenzgenerator 15 eingerechnet, so beläuft sich der gesamte Stromfluss auf etwa 7,8 mA, falls man die Differentialstufen jeweils mit 60 μA versorgt. Bei 1,2 V ergeben sich 9,4 mW Leistungsverbrauch. Die beschriebene Architektur kann damit 10 Bit bei Samplefrequenzen bis 200 MHz auflösen und verbraucht dabei weniger als 10 mW Leistung für das DC-Biasing (Gleichstrom-Versorgung).

Ein zweiter Aspekt des Konzeptes ist eine Kalibration.

Je nach Auslegung bzw. Dimensionierung der Schaltung kann es zu diversen Fehlerbildern bei der AD-Wandlung kommen. Diese entstehen u.a. durch Nichtidealitäten der Zwischenverstärker 16, ZV1 - ZV4, wie sie in Fig. 7 dargestellt sind. Eine konkave oder konvexe Charakteristik des Zwischenverstärkers 16 kann durch einen gain mismatch (Verstärkungs-Fehlanpassung) oder durch eine zu geringe settling-Zeit (Einstellzeit) verursacht werden (Fig. 7a). Ein unkorrelierter Offset (Versatz) zwischen den verschiedenen Zwischenverstärkern ZV1 - ZV4 führt zu einem fragmentierten Verlauf entsprechend Fig. 7b. Mit zunehmender Aussteuerung des Zwischenverstärkers wird die Sättigung der einzelnen Differentialstufen bzw. Verstärker zu einem dominanten Fehler (Fig. 7c).

Da die einzelnen Fehlerbilder bei den jeweiligen Zwischenverstärkern ZV1 - ZV4 unterschiedlich ausgeprägt sein können und sich überlagern, muss generell mit einer Charakteristik gemäß Fig. 8 gerechnet werden. Die exemplarischen Zahlen in Fig. 8 beziehen sich auf eine 6-Bit-Feinstufe mit einem Bit-Überhang. Der reale Ausgangscode des Feinwandlers 19 durchmisst den Bereich von 0 bis 63, wenn die Eingangsspannung das Referenzintervall normiert auf 64 durchläuft. Er folgt aufgrund der Fehlereinflüsse nicht dem gestrichelten idealen Verlauf. Die reale Kennlinie kann auch abhängig vom common mode (Mittenspannung) des differentiellen Eingangs variieren. Das nachfolgend beschriebene Kalibrationsverfahren geht näherungsweise davon aus, dass diese Varianz das Fehlerbild nicht wesentlich bestimmt. Die vorrangige Aufgabe der beschriebenen Kalibration besteht darin, bei ruhigen, nicht zu dynamischen Eingangssignalen die volle Auflösung zu gewährleisten.

Der Kalibrationsvorgang kann einmalig oder wiederholt durch das Anlegen und die Auswertung flacher Spannungsrampen an den GrobAnalog-Digital-Wandler und an die Arbitrierungsschaltung erfolgen. Dabei wird vorzugsweise der volle Referenzbereich in beiden Richtungen gemäß Fig. 9 durchlaufen. Die Steigung der Rampe pro Sampleperiode beträgt vorzugsweise weniger als ein LSB pro Takt geteilt durch die Anzahl der Zwischenverstärker gemäß $V_{pp}/(2^N * N_{ZV})$ mit $V_{pp}$ als differentieller peak-to-peak (Spitzenwert zu Spitzenwert) Spannung.

Die Rampe kann beispielsweise mittels einer Schaltung gemäß Fig. 10 erzeugt werden. Die exakte Steigung ist dabei unbekannt und darf lediglich den oben angegebenen Schwellwert nicht überschreiten, damit bei keiner Zwischenstufe ein missing code (fehlender Code) entsteht. Es handelt sich dabei um ein reines Prinzipschaltbild. Die robuste Erzeugung der Ströme kann aufwändig sein, wenn sie im Sub-$\mu$A-Bereich liegt. Die Rampengenerierung erfolgt über eine gepulste, gesteuerte Stromquelle gemäß Fig. 10, die eine Kapazität 31 auflädt. Diese Kapazität 31 lädt ihrerseits über einen hochohmigen hochziehenden Schalter pull_up oder über einen hochohmigen herunterziehenden Schalter pull_down eine Kalibrationskapazität 30. Durch das dadurch gegebene RC-Verhalten werden am Ausgang die Spannungspulse geglättet und näherungsweise wird eine Rampe erzeugt. Die Einkopplung des Kalibrationssignals geschieht vorzugsweise am insbesondere single ended (einseitig abgeschlossenen) Eingang des Signalpfades. Falls das Ausgangsnetz zu hohe Leckströme aufweist, wird ein Analogpuffer benötigt.

Gegenstand der beschriebenen Kalibrierung kann auch eine automatische oder manuelle Justierung, insbesondere I2C-Justierung (I2C: Programmierbares Einstell-Register) des Gains der Zwischenverstärker ZV1 - ZV4 sein durch eine Anpassung des Widerstandes in den einzelnen Verstärkerstufen, durch eine Anpassung des Widerstandes parallel zum Verstärkerausgang und/oder durch eine Variation des Biasstromes.

Die automatische Kalibration der Zwischenverstärker ZV1 - ZV4 kann durch das folgende Verfahren geschehen. Vorzugsweise wird die Kalibration für alle Stufen auf einmal durchgeführt.

Optional kann zuerst für jede Stufe oder für alle Stufen auf einmal eine Rampenfolge durchlaufen werden und dabei eine bestimmte Anzahl von Digitalwerten aufsummiert werden, vorzugsweise $2^n * 2^N$ Werte. Durch eine entsprechende Verschiebe- bzw. Shiftoperation und optionale Rundung wird der durchschnittliche Offset für jede Zwischenverstärkerstufe ermittelt und kann damit in der Applikation kompensiert werden, dass heißt von dem Feinergebnis abgezogen werden.

Dann wird die Differenz zwischen Ist und Soll an den Übergängen von einem Grobbit zum nächsten ermittelt (Fig. 7, 8). Wird eine Rampe gemäß Fig. 9 angelegt, so kommt es zu $2*2^M$ Übergängen, wenn eine Hysteresevorrichtung verhindert, dass aufgrund des Rauschens an den Grobschwellen Mehrfachzählungen auftreten. Daraus wird wiederum durch eine Rechtsverschiebung um M+1 Bit (shift_right >> M+1) und Rundung eine durchschnittliche Abweichung dl_av und dr_av für jeden Zwischenverstärker 16 ermittelt. In Fig. 8 sind exemplarisch die beidseitigen Soll-Istwert-Abweichungen dl und dh eingetragen.

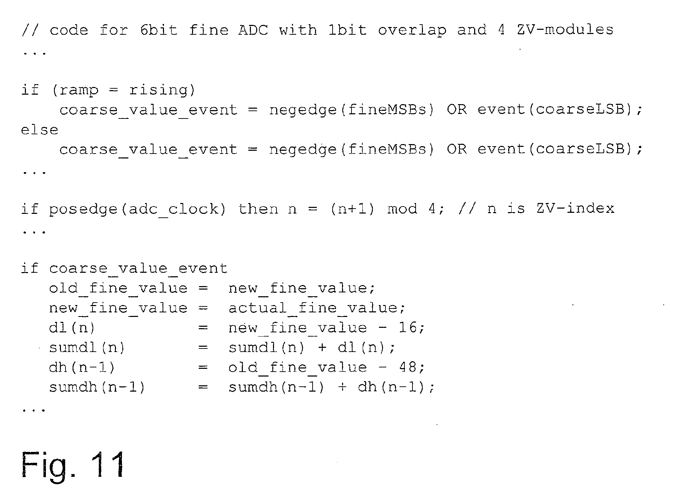

Ein Auszug einer möglichen algorithmischen Realisierung für 4 Zwischenverstärker ZV1 - ZV4 und 6 Bit zur Detektion und Verarbeitung von Soll-Istwert-Abweichungen dl und dh ist in Fig. 11 skizziert.

Der Algorithmus sieht den Sprung eines Grob-Bits (coarse_value_event) bei ansteigender bzw. fallender Rampe als gegeben an, wenn eine oder mehrere MSBs (höherwertige Bits) des Feinwandlers einen $1\rightarrow0$ bzw. $0\rightarrow1$ Übergang aufweisen oder das Grob-LSB (niedrigstes Bit) seinen Zustand ändert. Falls der Sprung eines Grob-Bits beispielsweise bei einer steigenden Rampe detektiert wurde, wird die Differenz dh des letzten Feinergebnisses, das noch dem vorhergehenden niedrigeren Grobintervall zuzuordnen ist, zu einem idealen Wert gebildet (gemäss Fig. 11 und Fig. 8 für 6Bit: Differenz zu 48) und außerdem die Differenz dl des aktuellen Feinergebnisses, das dem neu angefangenen Grobintervall zuzuordnen ist (gemäss Fig. 11 und Fig. 8 für 6Bit Differenz zu 16). Das letzte Feinergebnis der vorhergehenden Wandlung ist dafür jeweils als old_fine_value zu speichern.

Beide Differenzen werden beispielsweise in einem Akkumulator (sumdl und sumdh) aufsummiert, aus dem sich ein Maß für die durchschnittliche Höhe der Diskontinuitäten an den Grobübergängen ermitteln lässt.

Um die Diskontinuitäten eindeutig den Zwischenverstärkern zuordnen zu können, wird mit einem geeigneten Taktsignal des ADC-Wandlers ein Zähler betrieben, dessen Stand n als Identifikator für den jeweils relevanten Zwischenverstärker dient.

In Fig. 11 wird hierzu beispielhaft ein modulo-Wert zu vier bezüglich einer Anzahl von vier Zwischenverstärkern gebildet. Nachfolgend eine schriftliche Erläuterung des Codes aus Fig. 11:

Falls der Grobwert coarse_value_geändert ist, dann wird ein alter Wert old_fine_value gleich einem neuen Wert new_fine_value gesetzt. Der neue Wert new_fine_value wird dann mit dem momentanen Wert actual_fine_value belegt. Eine Variable für einen Sollwert dl(n) für den ersten Zweig wird gleich dem neuen Wert new_fine_value - 16 gesetzt und ein summierter Wert sumdl(n) für den ersten Zweig gleich dem bisherigen summierten Wert sumdl(n) plus dem Wert der Variable dl(n). Entsprechend werden eine Variable für einen Sollwert dh(n-1) durch Subtraktion von 48 und ein summierter Wert sumdh(n-1), dem dieser Wert dh(n-1) aufaddiert wird, für einen zweiten Zweig.

Falls erforderlich kann in dem Algorithmus eine Filterfunktion vorgesehen werden, die verhindert dass ein an den Grobübergängen auftretender zinnenförmiger Übergang mehrfach detektiert wird und die Durchschnittsbildung aus den Akkumulatorsummen verfälscht.

Die beiden durchschnittlichen Abweichungen vom Sollwert dl und dh werden für jede der Mittelstufen ermittelt und anschließend verwendet, um für jeden Wert des Fein-ADCs 13 einen Korrekturwert dig_cor zu bestimmen, der dem vorzeichenbehafteten Abstand zwischen linearisierter, grauer Linie und idealer gestrichelter Linie in Fig. 8 entspricht.

Die Bestimmung der Korrekturwerte dig_cor in Abhängigkeit von dl, dr und Feincode erfolgt insbesondere gemäß

$$x \leq 16: \qquad dig\_cor = \frac{dl \cdot x}{2^{N-M-2}},$$

$$16 < x < 48: \quad dig\_cor = dl + \frac{(dl - dr) \cdot \left(x - 2^{N-M-2}\right)}{2^{N-M-1}}$$

und

$$x \geq 48: \qquad dig\_cor = dr \cdot \frac{2^{N-M} - x}{2^{N-M-2}}. \qquad\qquad (3)$$

Der jeweilige Wert wird vorzugsweise im ADC-Betrieb für jedes Wandlerergebnis laufend ermittelt; er kann aber auch einmalig für alle Wandler berechnet und dann jeweils einer lookup-table (Nachschlagtabelle) entnommen werden.

Mit dem beschriebenen Kalibrationsverfahren werden einerseits die Sprünge zwischen aufeinanderfolgenden Grob-Übergängen idealerweise völlig kompensiert und andererseits die Abweichung zwischen realer und idealer Kennlinie auf den schraffierten Bereich in Fig. 8 reduziert.

Neben der dargestellten Ausführungsform des ADC sind verschiedene weitere Ausführungsformen umsetzbar. Da der zeitkritische Teil der vorliegenden Architektur eher in der Grobstufe liegt, kann diese zur Erreichung extrem hoher sample-Frequenzen mehrfach, insbesondere zweifach ausgeführt und im Multiplex betrieben werden.

Die Zwischenverstärker können auch in der Hochvolt-Domäne betrieben werden, beispielsweise unter Einsatz von Dioden mit z.B. 0,7 V als Überspannungsschutz. Die Zwischenverstärker hätten in diesem Fall einen größeren linearen Aussteuerbereich.

Eine Ausführung der Wandlerarchitektur als single ended circuit (einseitig abgeschlossene Schaltung) oder als pseudodifferentielle Schaltung ist ebenfalls möglich.

Als Eingangsstufe kann auch ein Pipeline-ADC vorgesehen werden. Der Zwischenverstärker erhält das differentielle Eingangssignal von dem vorausgehenden Residuenverstärker. Die Referenzspannungen werden gemäß dem Signal am Pipelineausgang mit dem sub-DAC ermittelt und generiert, beispielsweise mit gegensätzlicher Polarisierung. Wird etwa ein 5-Bit-Pipeline-ADC mit der beschriebenen Schaltung aus Zwischenverstärkern und einer 6-Bit-Flash-Endstufe abgeschlossen, kann dies zu einer erheblichen Verringerung des Leistungsverbrauchs beitragen.

Die Architektur kann dahingehend modifiziert werden, dass sie beispielsweise zwei insbesondere differentielle Signaleingänge im Multiplex-Verfahren wandelt.

Für eine Kalibration der Zwischenstufen sind insbesondere bei mehr als 10 Bit Auflösung aufwändigere Verfahren möglich. So könnte man die Zwischenverstärker automatisch solange variieren, bis bestimmte Fehlersummen minimiert werden, die mit Linearität, Steilheit und Offset der Kennlinien in Zusammenhang stehen.

Eine Speicherung des Fehlerprofils jedes Zwischenverstärkers in einer lookup-table bei verschiedenen common mode-Pegeln wäre ebenfalls möglich.

Weitere Vorteile des vorliegenden Konzepts bestehen neben den genannten. Durch RC-Tiefpass-Filterung in den Zwischenverstärkern werden Störungen reduziert. Zusammen mit der Vorverstärkung bewirkt das nachfolgende RC-Netzwerk im Teiler und im interpolierenden Feinwandler einen analogen Averaging Effect (Mittelungseffekt), eine digitale Nachbearbeitung, z.B. als bubble sort (sukzessive Sortierung durch Austausch je zweier benachbarter Komponenten) des Thermometer-Codes der Feinstufe ist nicht unbedingt erforderlich. Außerdem ist die Eingangslast durch jeweils einen durchgeschalteten Zwischenverstärker während der Samplingphase wesentlich geringer, als wenn sich an dessen Stelle eine Feinstufe befände.

Vorteilhaft ist eine Konzentration hoher Präzisionsanforderungen auf die Zwischenverstärker. Diese können optimal ausgelegt werden, ohne dass die Gesamtfläche oder der Leistungsverbrauch wesentlich steigt. Eine Umsetzung ist insbesondere möglich mit boosted switches, mit hohem Stromfluss, mit großen Transistorgeometrien oder auf matching optimiertem Layout.

Bei z.B. vierfacher Instanziierung der Zwischenverstärker bleibt effektiv für die Phase der Feinwandlung mehr Zeit. Die Verstärkung in der Endstufe erfolgt schneller, da eine Vorverstärkung in den Zwischenverstärkern stattgefunden hat und nur ein einzelner, differentieller Flashvorgang stattfindet. Daraus resultiert eine sehr hohe maximale Samplefrequenz bzw. Signalbandbreite.

Die beschriebene Architektur kann auch bei sehr niedrigen Versorgungsspannungen bzw. in den kleinsten Technologien mit z.B. 1 V / 90 nm implementiert werden.

## Patentansprüche

1. Analog-Digital-Konvertierungs-Schaltung zum Durchführen einer Analog-Digital-Konvertierung mit

   - einem Analog-Digital-Wandler (19) zum Umsetzen eines analogen Signals in digitale Daten,
   **gekennzeichnet durch**
   - zumindest einen Zwischenverstärker (16, ZV1 - ZV4) aus zumindest zwei Verstärkerstufen (A1, A2), wobei der Zwischenverstärker (16) dem Analog-Digital-Wandler (19) vorgeschaltet ist und der Analog-Digital-Wandler (19) in zeitlicher,Abfolge jeweils mit dem Ausgang der Verstärkerstufen (A1, A2) eines Zwischenverstärkers (16, ZV1-ZV4) beschaltet wird.

2. Schaltung nach Anspruch 1, bei der/die Verstärkerstufen (A1, A2) jeweils als eine unausgesteuerte Verstärkerstufe ausgebildet sind und eine Ausgangsspannung besitzen, die in guter Näherung ihrer Eingangsspannung proportional ist.

3. Schaltung nach Anspruch 2, bei der die Ausgangsspannungen zweier solcher Verstärkerstufen (A1, A2) als Zwischenverstärker abwechselnd jeweils mit unterschiedlichen, insbesondere differentiellen Referenzspannungspaaren, aber mit derselben differentiellen Signalspannung beschaltet werden.

4. Schaltung nach Anspruch 3, bei der die Referenzspannungspaare differentielle Referenzspannungspaare sind.

5. Schaltung nach einem der vorstehenden Ansprüche, bei welcher der oder die Zwischenverstärker (16) verschaltet ist/sind mittels des nachfolgenden Analog-Digital-Wandlers (19) die Ermittlung der Lage von Signalspannungen (inp, inn) relativ zu Referenzspannungen (refh, refl, refhh, refll) durchzuführen.

6. Schaltung nach einem der vorstehenden Ansprüche, bei welcher der oder die Zwischenverstärker (16) verschaltet ist/sind als eine Mittelstufe zwischen einem Grob-Analog-Digital-Wandler (13 - 15) als vorhergehende Stufe und einem Fein-Analog-Digital-Wandler (17 - 19) als nachfolgende Stufe.

7.  Schaltung nach Anspruch 6, bei welcher der Grob-Analog-Digital-Wandler (13 - 15) und/oder der Fein-Analog-Digital-Wandler (17 - 19) jeweils mit averaging und interpolation Techniken implementiert sind.

8.  Schaltung nach Anspruch 7, bei welcher der Fein-Analog-Digital-Wandler (17 - 19) in seiner ersten Stufe mit resistivem Averaging umgesetzt ist.

9.  Schaltung nach Anspruch 6, 7 oder 8, bei welcher der/die Zwischenverstärker (16) mit einem Referenzspannungsausschnitt beschaltet werden, der aus einem Resultat der vorhergehenden Stufe generiert wird.

10. Schaltung nach einem der Ansprüche 6 bis 9, bei welcher der/die Zwischenverstärker (16) als Mittelstufe aus mehreren nebenläufig arbeitenden Zwischenverstärkern (16, ZV1 - ZV4) zusammen geschaltet sind.

11. Schaltung nach Anspruch 10, bei welcher den Zwischenverstärkern (16) eine Arbitrierungsschaltung (12) vorgeschaltet und ein Multiplexer (17) nachgeschaltet ist.

12. Schaltung nach Anspruch 11 mit einer an den Grob-Analog-Digital-Wandler (13 - 15) und/oder den Fein-Analog-Digital-Wandler (17 - 19) geschalteten Kalibrierungsschaltung (11) zum Anlegen und Auswerten einer insbesondere flachen Spannungsrampe an den Grob-Analog-Digital-Wandler (13 - 15) und die Arbitrierungsschaltung (12).

13. Schaltung nach einem der vorstehenden Ansprüche, bei welcher die Zwischenverstärker (16, ZV1 - ZV4) jeweils ausgebildet sind durch einen kapazitiven Ring (C), der zwischen Ausgänge zweier Verstärker (A1, A2) mit Ausgangssignalen (V1h, V11 bzw. V2h, V21) geschaltet ist und der mittels Flash-Schaltern (22) ausgelegt ist, in einer Flash-Phase zusätzlich zu den Zwischenverstärkern eine Analog-Digital-Wandler-Endstufe zu treiben.

14. Schaltung nach Anspruch 13, bei welcher die Zwischenverstärker (16, ZV1 - ZV4) geschaltet sind, eine Differenz zu anliegenden Referenzsignalen (refhh, refll) zu verstärken.

15. Analog-Digital-Konvertierungsverfahren, bei dem

    - ein analoges Signal (inp, inn) in digitale Daten umgesetzt wird,

    **dadurch gekennzeichnet , dass**

    - das analoge Signal einer Grob-Analog-Digital-Konvertierung in einem ersten Analog-Digital-Wandler (13) einer ersten Stufe (13 - 15) angelegt wird,
    - das analoge Signal zusätzlich einer Zwischenverstärkung in zumindest einem Zwischenverstärker (16, ZV1 - ZV4) aus zumindest zwei Verstärkerstufen (A1, A2) angelegt wird,
    - der Zwischenverstärkung zusätzlich ein in der ersten Stufe erzeugtes Referenzsignal (refh, refl, refhh, refll) angelegt wird und
    - ein durch die Zwischenverstärkung unter Einsatz des Referenzsignals und des analogen Signals erzeugtes Ausgangssignal einer Fein-Analog-Digital-Konvertierung einer dritten Stufe (17 - 19) mit einem zweiten Analog-Digital-Wandler (19) zum Bereitstellen der digitalen Daten angelegt wird.

16. Verfahren nach Anspruch 15, bei dem
    mittels zweier unausgesteuerter Verstärkerstufen (A1, A2) mit einer Ausgangsspannung, die in insbesondere guter Näherung ihrer Eingangsspannung proportional ist, jeweils ein solcher Zwischenverstärker (16) ausgebildet wird, wobei die Verstärkerstufen (A1, A2) abwechselnd jeweils mit den unterschiedlichen, insbesondere differentiellen Referenzspannungspaaren (refh, refl, refhh, refll), aber mit der selben differentiellen Signalspannung (inp, inn) beschaltet werden.

17. Verfahren nach Anspruch 15 oder 16, bei dem
    mittels der Zwischenverstärker und dem zweiten Analog-Digital-Wandler (19) eine Ermittlung einer Lage der Signalspannungen (inp, inn) relativ zu den Referenzspannungen (refh, refl, refhh, refll) durchgeführt wird.

18. Verfahren nach einem der Ansprüche 15 bis 17, bei dem die Zwischenverstärker mit einem Referenzspannungsausschnitt beschaltet werden, der aus dem Resultat der ersten Stufe generiert wird.

19. Verfahren nach einem der Ansprüche 15 bis 18, bei dem
ein Kalibrationsvorgang einmalig oder wiederholt durch ein Anlegen und eine Auswertung einer flachen Spannungsrampe durchgeführt wird, wobei das Anlegen an den Grob-Analog-Digital-Wandler (13) und an eine den Zwischenverstärkern (16, ZV1 - ZV4) vorgeschaltete Arbitrierungsschaltung (12) durchgeführt wird.

Fig. 1

Fig. 2

$$S = ( V(inp) > V(inn) )$$

$$\overline{S} = (V(inp < V(inn)))$$

Fig. 3

Fig. 4

Fig. 5

Grobwandler   12 - 15

sample_c

compare_c

Zwischenverstärker   16, ZV1 - ZV4

sample_ZV1

compare_ZV1

flash_ZV1

sample_ZV2

compare_ZV2

flash_ZV2

sample_ZV3

compare_ZV3

flash_ZV3

sample_ZV4

compare_ZV4

flash_ZV4

Feinwandler  17 - 19

compare_f

reset

digit_out

# Fig. 6

digital out ( $N_{bit}$ -> inf )

analog in ( abs(V(inp) -V(inn)) )

ⓐ        ⓑ        ⓒ

Fig. 7 Fehlerbilder aufgrund   a) gain mismatch   b) offset   c) saturation

lineare Korrektur

real

ideal

$inc\_dec = +2^{N-M}$

$inc\_dec = -2^{N-M}$

5+1 bit
Feinwandler

Fig. 8

Fig. 9

Fig. 10

```
// code for 6bit fine ADC with 1bit overlap and 4 ZV-modules
...

if (ramp = rising)
    coarse_value_event = negedge(fineMSBs) OR event(coarseLSB);
else
    coarse_value_event = negedge(fineMSBs) OR event(coarseLSB);
...

if posedge(adc_clock) then n = (n+1) mod 4; // n is ZV-index
...

if coarse_value_event
    old_fine_value =  new_fine_value;
    new_fine_value =  actual_fine_value;
    dl(n)          =  new_fine_value - 16;
    sumdl(n)       =  sumdl(n) + dl(n);
    dh(n-1)        =  old_fine_value - 48;
    sumdh(n-1)     =  sumdh(n-1) + dh(n-1);
...
```

# Fig. 11

**IN DER BESCHREIBUNG AUFGEFÜHRTE DOKUMENTE**

**In der Beschreibung aufgeführte Nicht-Patentliteratur**

- *IEEE JOURNAL OF SOLID-STATE CIRCUITS,* Mai 1999, vol. 34 (5